(19) **Europäisches Patentamt**
**European Patent Office**
**Office européen des brevets**

(11) **EP 1 507 285 B1**

(12) **EUROPEAN PATENT SPECIFICATION**

(45) Date of publication and mention
of the grant of the patent:
**04.01.2012 Bulletin 2012/01**

(51) Int Cl.:
***H01L 21/02*** (2006.01)

(21) Application number: **04254810.7**

(22) Date of filing: **10.08.2004**

(54) **Capacitor of semiconductor device and memory device using the same**

Kondensator einer Halbleiter-Anordnung und entsprechendes Speicherbauelement

Condensateur de composant sémiconducteur et cellule de mémoire correspondante

(84) Designated Contracting States:
**DE FR GB**

(30) Priority: **13.08.2003 KR 2003056034**

(43) Date of publication of application:
**16.02.2005 Bulletin 2005/07**

(73) Proprietor: **SAMSUNG ELECTRONICS CO., LTD.**
**Suwon-city,**
**Gyeonggi-do (KR)**

(72) Inventors:
• **Lee, Jung-hyun**
**Yongin-si**
**Gyeonggi-do (KR)**
• **Seo, Bum-seok**
**Seoul (KR)**

(74) Representative: **Greene, Simon Kenneth**
**Elkington and Fife LLP**
**Prospect House**
**8 Pembroke Road**
**Sevenoaks**
**Kent TN13 1XR (GB)**

(56) References cited:
**EP-A- 0 046 868        US-A1- 2002 030 191**
**US-A1- 2002 115 252    US-A1- 2003 036 239**
**US-A1- 2003 096 473    US-B1- 6 207 489**

**Description**

The present invention relates to a semiconductor device, and more particularly, to a capacitor of a semiconductor device and a memory device using the same.

A semiconductor device, such as a memory device, includes a transistor and a capacitor. The capacitor should maintain data in a normal state for a long time. To do this, the capacitor has a capacitance that is greater than a certain value.

As a degree of integration of the memory device is increased, an area where a capacitor is formed is decreased. Nevertheless, a capacitance of a capacitor should be increased or at least not decreased.

According to this situation, research for a capacitor which can be applied to a highly integrated memory device has been progressed. In the research, a method of thinning a dielectric layer, a method of utilizing ferroelectric substances, and a method of combining the two methods are used.

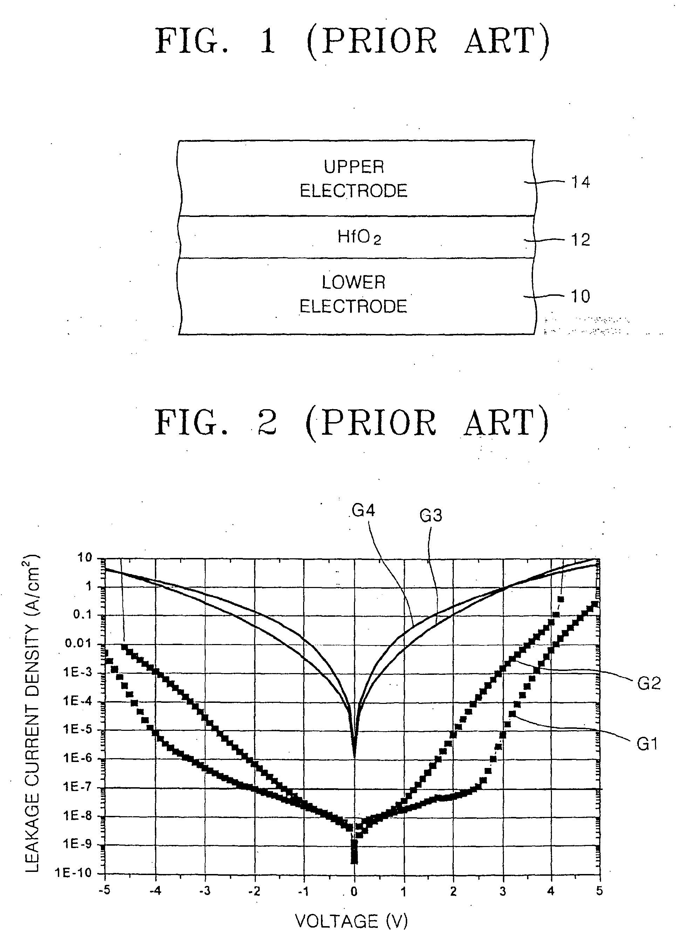

FIG. 1 is a cross-sectional view of a capacitor included in a semiconductor device according to prior art.

Referring to FIG. 1, a conventional capacitor includes a lower electrode 10, a hafnium oxide layer 12, and an upper electrode 14.

As the degree of integration of the memory device is increased, a leakage current of the conventional capacitor is increased.

That is, it is preferable that the hafnium oxide layer 12 which is used as a dielectric layer, be as thin as possible. However, as the hafnium oxide layer 12 becomes thin, for example, around 4.5nm thick, the leakage current of a capacitor dramatically increases. Thus, the memory device including the conventional capacitor does not work properly.

FIG. 2 is a graph illustrating a leakage current density of the capacitor of FIG. 1 according to the thickness of the hafnium oxide layer 12.

Referring to FIG. 2, first and second curves G1 and G2 illustrate the characteristics of the leakage current when the hafnium oxide layer 12 is much thicker than 4.5nm, while the third and fourth curves G3 and G4 illustrate the characteristics of the leakage current when the hafnium oxide layer 12 is about 4.5nm thick. Moreover, the first and third curves G1 and G3 represent leakage current density when the hafnium oxide layer 12 is deposited to a thickness than thinner a target thickness. In addition, the second and fourth curves G2 and G4 represent the leakage current density when the hafnium oxide layer 12 is deposited to the target thickness. Comparing the first and second curves G1 and G2 with the third and fourth curves G3 and G4, the leakage current of the capacitor dramatically increases when the hafnium oxide layer 12 is about 4.5nm thick.

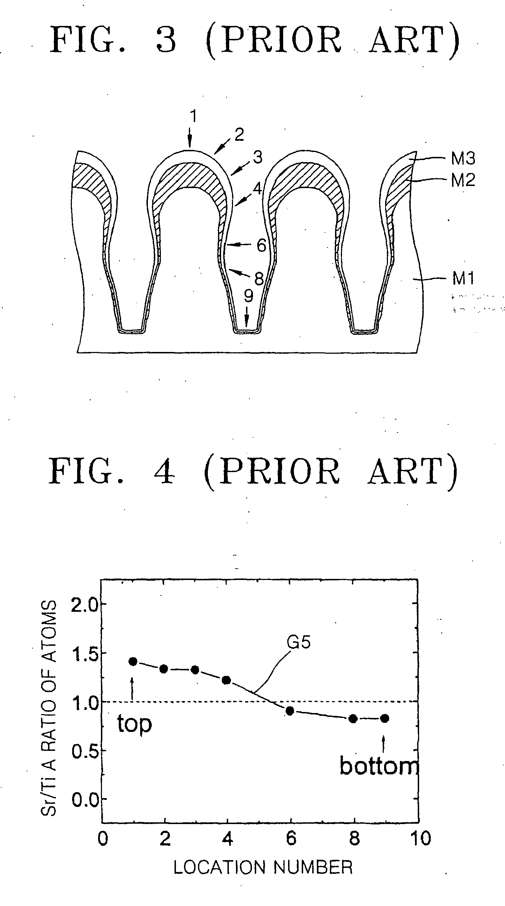

A ferroelectric layer having multi-components, such as an STO ($SrTiO_3$) layer, may be used, instead of the hafnium oxide layer 12. When the capacitor has a complicated structure like the capacitor in FIG. 3, a ratio of positive ions in a ferroelectric layer M3 changes and an electrical characteristic of the capacitor is degraded. Referring to FIG. 4, the fifth curve G5 illustrates a ratio of Sr to Ti in the ferroelectric layer M3, for example, the STO layer which is measured at a plurality of points 1...9 in the capacitor in FIG. 3.

According to the fifth curve G5, while the content of Sr at the top surface of the ferroelectric layer M3 is much than that of Ti. However, the content of Ti at the bottom surface of the ferroelectri layer M3 is little than that of Sr.

An upper electrode is not shown in the capacitor of FIG. 3. In FIG. 3, a reference character M1 indicates silicon oxide ($SiO_2$) layer and a reference character M2 indicates a lower electrode.

US 2002/0116252 describes a thin dielectric structure, in which ultra thin layers of $Al_2O_3$, up to 1.5 nm, are used to sandwich high-k dielectric, typically $Zr_2O_3$.

Another capacitor dielectric structure is described in US 2002/0030191 which describes a dielectric layer between silicon dioxide layers. The dielectric layer may be of a high-k dielectric.

According to an aspect of the present invention, there is provided a capacitor of a semiconductor device according to claim 1.

In specific embodiments, the dielectric layer comprising: a first dielectric layer that has a first band gap and is formed on the lower electrode; a second dielectric layer that has a second band gap and is formed on the first dielectric layer; and a third dielectric layer that has a third band gap and is formed on the second dielectric layer.

The first through third band gaps may satisfy at least one among the following conditions:

> i) the second band gap < the first band gap = the third band gap
> ii) the second band gap < the first band gap < the third band gap
> iii) the second band gap < the third band gap < the first band gap

In addition, a dielectric layer that has a band gap between the first and second band gaps is further included between the first and second dielectric layers. Also, a dielectric layer that has a band gap between the second and third band gaps is further included between the second and third dielectric layers.

According to another aspect of the present invention, there is provided a memory device comprising: a transistor;

and a capacitor connected to the transistor, wherein the capacitor comprises: a lower electrode connected to the transistor; a dielectric layer which has a plurality of band gaps, formed on the lower electrode; and an upper electrode formed on the dielectric layer.

Accordingly, the capacitor including the nano-thick dielectric layer, and having the large capacitance and a leakage current that is lower than a conventional capacitor can be realized using the above present invention. Also, a highly reliable memory device can be realized.

The present invention provides a capacitor of a semiconductor device, including a dielectric layer, that may be formed to be a nanometer thick and having large capacitance and an excellent leakage current characteristic along with a memory device using the capacitor.

The above and other features and advantages of the present invention will become more apparent by describing in detail exemplary embodiments thereof with reference to the attached drawings in which:

FIG. 1 is a cross-sectional view of a conventional capacitor included in a semiconductor device;
FIG. 2 is a graph illustrating a leakage current density of the capacitor of FIG. 1 according to the thickness of a hafnium oxide layer included in the capacitor of FIG. 1;
FIG. 3 is a cross-sectional view of a conventional capacitor having a ferroelectric layer, but a complete structure;
FIG. 4 is a graph illustrating ratio of atoms included in the ferroelectric layer of FIG. 3, measured at a plurality of points in the capacitor of FIG. 3;
FIG. 5 is a cross-section of a capacitor of a semiconductor device according to an embodiment of the present invention;
FIG. 6 is a graph illustrating leakage current density of the capacitor of FIG. 5, which is measured before stacking a dielectric layer;
FIG. 7 is a graph illustrating leakage current density of the capacitor of FIG. 5 after stacking a dielectric layer; and
FIG. 8 is a cross-sectional view of a memory device including the capacitor of the semiconductor device of FIG. 5 according to an embodiment of the present invention.

The present invention will now be described more fully with reference to the attached drawings, in which exemplary embodiments thereof are shown. This invention may, however, be embodied in many different forms and should not be construed as being limited to the embodiments set forth herein; rather these embodiments are provided so that this disclosure will be thorough and complete, and will fully convey the concept of the invention to those skilled in the art. In the drawings, the forms of the elements are exaggerated for clarity. To facilitate understanding, identical reference numerals have been used for like elements throughout the figures.

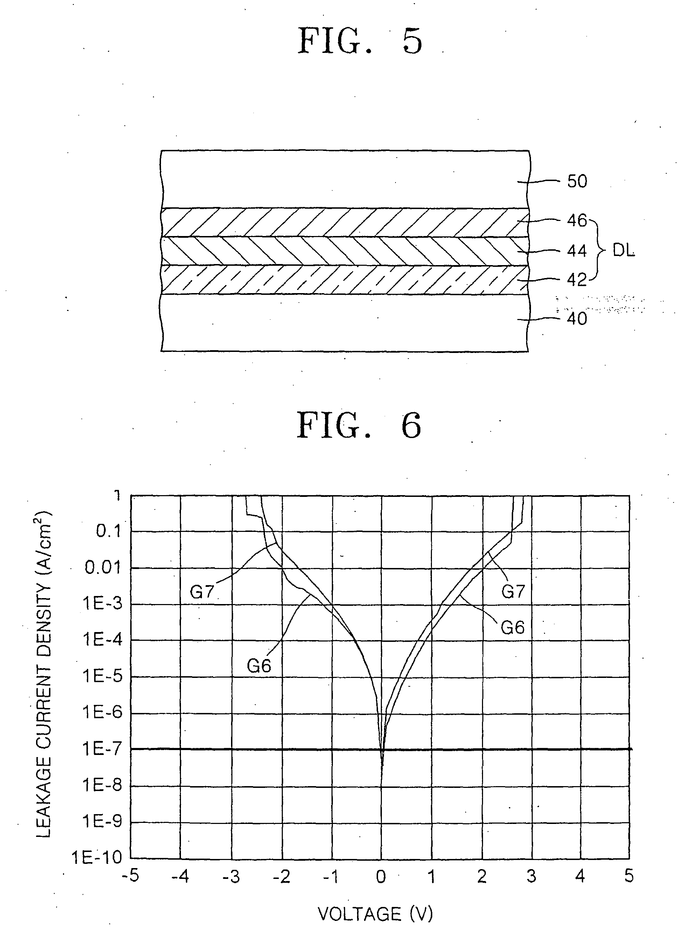

FIG. 5 is a cross-section of a capacitor of a semiconductor device according to an embodiment of the present invention.

Referring to FIG. 5, a capacitor by the present invention includes a lower electrode 40 and an upper electrode 50 which faces the lower electrode 40.

The lower electrode 40 is preferably an Si layer in which conductive impurities are doped. However, other conductive layers, such as a TiN layer, may be used. The upper electrode 50 is preferably a TiN layer. However, other conductive layers, such as an Si layer in which conductive impurities are doped, may be used. A dielectric layer DL exists between the lower electrode 40 and the upper electrode 50.

The dielectric layer DL is formed by sequentially depositing dielectric layers having a different band gap, thereby having a different dielectric constant.

In specific, the dielectric layer DL is formed by sequentially forming three different dielectric layers. That is, a first dielectric layer 42 is formed on the lower electrode 40, a second dielectric layer 44 is formed on the first dielectric layer 42, and a third dielectric layer 46 is formed on the second dielectric layer 44. The first dielectric layer 42 has a first band gap, the second dielectric layer 44 has a second band gap, and the third dielectric layer 46 has a third band gap. The second band gap is preferably smaller than the first band gap and the third band gap. It is additionally preferable that the first and third band gaps are equivalent.

If the first through third dielectric layers 42, 44, and 46 have the above band gap distribution, electrons passing through one of the dielectric layers having the large band gap, for example, the third dielectric layer 46, encounters a dielectric layer having a small band gap, that is, the second dielectric layer 44, and causes phonon scattering. Accordingly, the electrons cannot pass through the band gap adjacent to the second dielectric layer 44, that is, the first dielectric layer 42.

As a result, the leakage current of the dielectric layer DL is reduced. The leakage current is reduced due to the relationship between the band gaps of the first through third dielectric layers 42, 44, and 46 forming the dielectric layer DL rather than the thickness of the first through third dielectric layers 42, 44, and 46. Thus, even if the thickness of the first through third dielectric layers 42, 44, and 46 becomes thin, the leakage current characteristic of the dielectric layer DL can be maintained excellently. Therefore, the dielectric layer DL is formed to a thin thickness. For example, the first through third dielectric layers 42, 44, and 46 may be formed to a thickness of 2nm ~ 10 nm.

It preferable that the first through third dielectric layers 42, 44, and 46 have the same thickness in a range of 2nm ~10nm.

It is preferable that each of the first and third dielectrics layers 42 and 46 is one selected from the group consisting of a hafnium oxide layers ($HfO_2$), an aluminium oxide layer ($Al_2O_3$), and a praseodymium oxide layer ($Pr_2O_3$). It is preferable that the second dielectric layer 44 is a titanium oxide layer ($TiO_2$), but may also be one selected from the group consisting of a tantalum oxide layer ($Ta_2O_5$), an STO($SrTiO_3$) layer, a BTO($BaTiO_3$) layer, a PTO($PbTiO_3$) layer, a TNO($(Ta, Nb)_2O_5$) layer, and a TWO($(Ta, W)_2O_5$).

Experiments to test the superiority of the leakage current characteristic of the capacitor according to the embodiment of the present invention will now be described.

In a first experiment, the first through third dielectric layers 42, 44, and 46 are formed with an LaO layer, a $TiO_2$ layer, and an LaO layer, respectively. In a second experiment, the first through third dielectric layers 42, 44, and 46 are formed with a HfO layer, a $TiO_2$ layer, a HfO layer, respectively. The total thickness of the first through third dielectric layers 42, 44, and 46 are formed to be about a nano-thick.

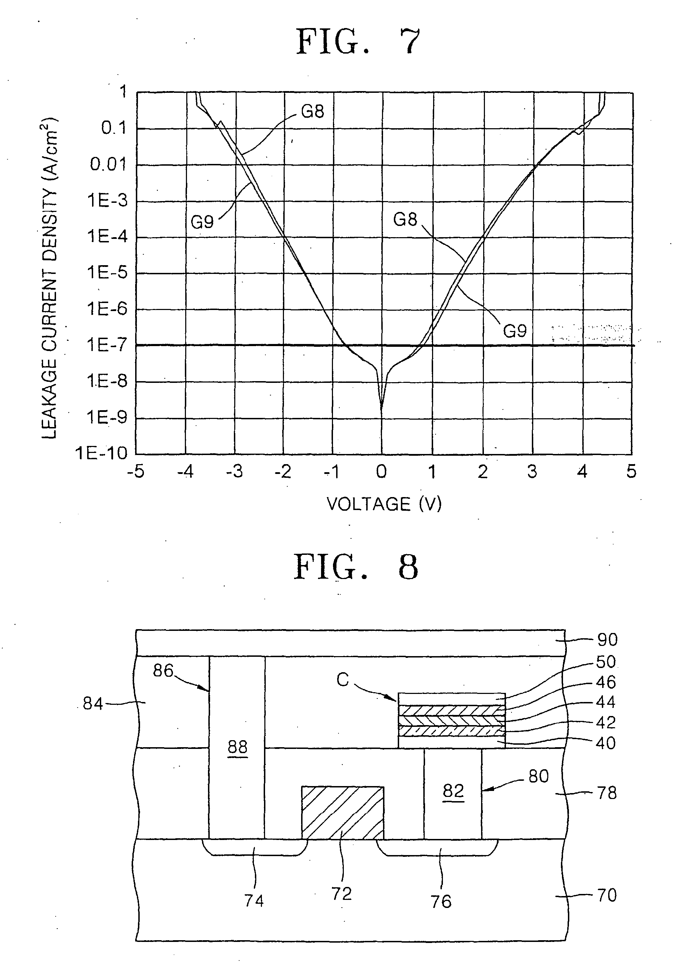

FIGS. 6 and 7 are graphs illustrating the results of the above experiments.

FIG. 6 illustrates a first leakage current density measured before stacking the first through third dielectric layers 42, 44, and 46 to a target thickness, for example, measured after stacking only the first dielectric layer 42. FIG. 7 illustrates a second leakage current density of the capacitor of FIG. 5 after completely forming the first through third dielectric layers 42, 44, and 46 to the target thickness.

Referring to FIGS. 6 and 7, sixth and eighth curves G6 and G8 illustrate the leakage current density measured at one place of a substrate which is placed horizontally and seventh and ninth curves G7 and G9 illustrate the leakage current density measured at another place of the substrate.

The one place may be one location near a flat zone of the substrate and the another place may be other location on an opposite side of the flat zone.

It can be seen from a comparison of the graphs of FIG. 6 with the graphs of FIG. 7 that the second leakage current density is much less than the first current density.

Furthermore, when comparing the third and fourth curves G3 and G4 of FIG. 2 with the eighth and ninth curves G8 and G9 of FIG. 7, when a predetermined voltage, for example, $\pm1V$, is applied, leakage current density of the conventional capacitor is about 0.01 A/cm$^2$, but the leakage current intensity of the capacitor according to an embodiment of the present invention ranges between 1E-7A/cm$^2$ and 1E-6A/cm$^2$.

Thus, the leakage current density of the capacitor according to an embodiment of the present invention is much lower than that of the conventional capacitor, and thus, the capacitance of the capacitor according to the embodiment of the present invention is much greater than that of the conventional capacitor.

In the meantime, the capacitor of FIG. 5 can be formed by successively stacking the first through third dielectric layers 42, 44, and 46 on the lower electrode 40 and then the upper electrode 50 on the third dielectric layer 46. The first through third dielectric layers 42, 44, and 46 may be formed in a range of 2nm and 10nm thick.

Moreover, a chemical vapor deposition (CVD) method may also be used to form the first through third dielectric layers 42, 44 and 46. Considering that the first through third dielectric layers 42, 44 and 46 are formed to a thickness of a nano-level, it is preferable that the first through third dielectric layers 42, 44, and 46 are formed by an atomic layer deposition (ALD).

A memory device including the capacitor of FIG. 5 will be described.

FIG. 8 is a cross-sectional view of a memory device including the capacitor of the semiconductor device of FIG. 5 according to an embodiment of the present invention.

Referring to FIG. 8, the memory device includes a substrate 70. The substrate 70 includes first and second areas 74 and 76 in which impurities are injected and which are separated by a predetermined distance. The first area 74 is a source area and the second area 76 is a drain area. A channel area is located in the substrate 70 between the first and second areas 74 and 76 and a gate stacking material 72 is formed on the channel area. The gate stacking material 72 turns the channel area on or off according to the applied voltage. The gate stacking material 72 includes a gate insulating layer (not shown) and a gate conductive layer (not shown). The substrate 70, the first and second areas 74 and 76, and the gate stacking material 72 constitutes a MOSFET. A first interlayer insulating layer 78 covering the gate stacking material 72 is formed on the substrate 70 and a first contact hole 80 that exposes the second area 76 is formed in the first interlayer insulating layer 78. The first contact hole 80 is filled with a first conductive plug 82, for example, polysilicon doped with conductive impurities. A capacitor C covering the first conductive plug 82 is formed on the first interlayer insulating layer 78. The capacitor C is preferably the capacitor shown in FIG. 5. It is also preferable that the lower electrode 40 of the capacitor C and the first conductive plug 82 are preferably formed with the same conductive material, however different conductive materials may be used. A second interlayer insulating layer 84 covering the capacitor C is formed on the first interlayer insulating layer 78. A second contact hole 86 that exposes part of the first area 74 is formed in the first and second interlayer insulating layers 78 and 84. The second contact hole 86 is filled with a second conductive plug 88. It is preferable that the second conductive plug 88 is polysilicon doped with conductive impurities, but other conductive materials may also be used. A conductive layer 90 covering the second conductive plug 88 is formed on the second interlayer insulating layer 84. The conductive layer 90 is a bit line and is vertical to the gate stacking material 72. It is preferable that the conductive layer 90 and the second conductive plug 88 are formed with the same conductive material, but different conductive materials may be used.

In the memory device by the present invention, data stored in the capacitor can be maintained for a long time in a normal state. That is, this means that the data stored in capacitor can be read normally even when reading the data after the data is stored and a long time flows, and thus, the reliability of the memory device is enhanced.

As described above, the dielectric layer of the capacitor according to exemplary embodiments of the present invention includes a plurality of dielectric layers that have different band gaps. Electrons that pass through the dielectric layers that have a large band gap compared to the other dielectric layers can be phonon scattering when they reach a dielectric layer having a smaller band gap. Therefore, the electrons cannot pass through the dielectric layer with the large band gap which is placed next to the dielectric layer having the small band gap. Thus, even if the dielectric layer of the capacitor has a thickness of a nano-level, the leakage current of the capacitor is not increased. In addition, the thickness of the dielectric layer has a thickness of a nano-level. Accordingly, the capacitance of the capacitor is largely enhanced.

Although the detailed description is presented here, this invention may be embodied in many different forms and should not be construed as being limited to the embodiments set forth herein; rather the aforementioned preferred embodiments are provided so that this disclosure will be thorough and complete, and will fully convey the concept of the invention to those skilled in the art. For instance, the first and third dielectric layers 42 and 46 may be replaced with dielectric layers which have different band gaps, but are larger than that of the second dielectric layer 44. Furthermore, a plurality of second dielectric layers 44 may include between the first and third dielectric layers 42 and 46. Also, another dielectric layer having the same band gap with the first or third dielectric layer may further be included in the plurality of second dielectric layers 44. In addition, another dielectric layer having a band gap smaller than that of the second dielectric layer 44 may further be included between the plurality of second dielectric layers 44. This capacitor may also be used in other memory devices besides the memory device of FIG. 8.

While the present invention has been particularly shown and described with reference to exemplary embodiments thereof, it will be understood by those of ordinary skill in the art that various changes in form and details may be made therein without departing from the scope of the present invention as defined by the following claims.

**Claims**

1. A capacitor of a semiconductor device, the capacitor comprising:

   a lower electrode (40);
   a first dielectric layer (42) that has a first band gap and is formed on the lower electrode (40);
   a second dielectric layer (44) that has a second band gap and is formed on the first dielectric layer (42);
   a third dielectric layer (46) that has a third band gap and is formed on the second dielectric layer (44); and
   an upper electrode (50) formed on the third dielectric layer (46);
   **characterised in that** the first dielectric layer is one selected from the group consisting of an $HfO_2$ layer, an $La_2O_3$ layer and a $Pr_2O_3$ layer;
   and the third dielectric layer is one selected from the group consisting of an $HfO_2$ layer, an $La_2O_3$ layer and a $Pr_2O_3$ layer;
   wherein each of the first through third dielectric layers (42, 44, 46) have a thickness from 2 nm to 10 nm.

2. The capacitor of claim 1, wherein the first through third band gaps satisfy:

   the second band gap < the first band gap = the third band gap.

3. The capacitor of claim 1, wherein the first through third band gaps satisfy:

   the second band gap < the first band gap < the third band gap.

**4.** The capacitor of claim 1, wherein the first through third band gaps satisfy:

$$\text{the second band gap} < \text{the third band gap} < \text{the first band gap}.$$

**5.** The capacitor of any of claims 1 to 4, wherein a dielectric layer having a band gap between the first and second band gaps is further provided between the first and second dielectric layers.

**6.** The capacitor of any of claims 1 to 5, wherein a dielectric layer having a band gap between the second and third band gaps is further provided between the second and third dielectric layers.

**7.** The capacitance of any of claims 1 to 6 wherein the second dielectric layer is one selected from the group consisting of a $TiO_2$ layer, a $Ta_2O_5$ layer, an $SrTiO_3$ layer, a $BaTiO_3$ layer, a $PbTiO_3$ layer, a $(Ta, Nb)_2O_5$ layer, and a $(Ta, W)_2O_5$ layer;

**8.** A memory device of a semiconductor device comprising:

a transistor (72, 74, 76); and
a capacitor (40, 42, 44, 46, 50) connected to the transistor, wherein the capacitor comprises a capacitor according to any preceding claim.

**Patentansprüche**

**1.** Kondensator eines Halbleiterbauelements, wobei der Kondensator umfasst:

eine untere Elektrode (40),
eine erste dielektrische Schicht (42), die eine erste Bandlücke aufweist und auf der unteren Elektrode (40) ausgebildet ist,
eine zweite dielektrische Schicht (44), die eine zweite Bandlücke aufweist und auf der ersten dielektrischen Schicht (42) ausgebildet ist,
eine dritte dielektrische Schicht (46), die eine dritte Bandlücke aufweist und auf der zweiten dielektrischen Schicht (44) ausgebildet ist, und
eine obere Elektrode (50), die auf der dritten dielektrischen Schicht (46) ausgebildet ist,
**dadurch gekennzeichnet, dass** die erste dielektrische Schicht ausgewählt ist aus der Gruppe bestehend aus einer $HfO_2$-Schicht, einer $La_2O_3$-Schicht und einer $Pr_2O_3$-Schicht,
und die dritte dielektrische Schicht ausgewählt ist aus der Gruppe bestehend aus einer $HfO_2$-Schicht, einer $La_2O_3$-Schicht und einer $Pr_2O_3$-Schicht,
wobei jede der ersten bis dritten dielektrischen Schichten (42, 44, 46) eine Dicke von 2 nm bis 10 nm aufweist.

**2.** Kondensator nach Anspruch 1, wobei für die erste bis dritte Bandlücke gilt:

$$\text{zweite Bandlücke} < \text{erste Bandlücke} = \text{dritte Bandlücke}.$$

**3.** Kondensator nach Anspruch 1, wobei für die erste bis dritte Bandlücke gilt:

$$\text{zweite Bandlücke} < \text{erste Bandlücke} < \text{dritte Bandlücke}.$$

**4.** Kondensator nach Anspruch 1, wobei für die erste bis dritte Bandlücke gilt:

$$\text{zweite Bandlücke} < \text{dritte Bandlücke} < \text{erste Bandlücke}.$$

**5.** Kondensator nach einem der Ansprüche 1 bis 4, wobei weiter zwischen der ersten und zweiten dielektrischen Schicht eine dielektrische Schicht mit einer Bandlücke zwischen der ersten und zweiten Bandlücke vorgesehen ist.

**6.** Kondensator nach einem der Ansprüche 1 bis 5, wobei weiter zwischen der zweiten und dritten dielektrischen Schicht eine dielektrische Schicht mit einer Bandlücke zwischen der zweiten und dritten Bandlücke vorgesehen ist.

**7.** Kondensator nach einem der Ansprüche 1 bis 6, wobei die zweite dielektrische Schicht ausgewählt ist aus der Gruppe bestehend aus einer $TiO_2$-Schicht, einer $Ta_2O_5$-Schicht, einer $SrTiO_3$-Schicht, einer $BaTiO_3$-Schicht, einer $PbTiO_3$-Schicht, einer $(Ta, Nb)_2O_5$-Schicht und einer $(Ta, W)_2O_5$-Schicht.

**8.** Speicherbauelement eines Halbleiterbauelements, umfassend:

einen Transistor (72, 74, 76) und
einen (Kondensator (42, 44, 46, 50), der mit dem Transistor verbunden ist, wobei der Kondensator einen Kondensator nach einem der vorhergehenden Ansprüche umfasst.


**Revendications**

**1.** Condensateur d'un dispositif semi-conducteur, le condensateur comprenant :

une électrode inférieure (40) ;
une première couche diélectrique (42) qui a une première bande interdite et qui est formée sur l'électrode inférieure (40) ;
une deuxième couche diélectrique (44) qui a une deuxième bande interdite et qui est formée sur la première couche diélectrique (42) ;
une troisième couche diélectrique (46) qui a une troisième bande interdite et qui est formée sur la deuxième couche diélectrique (44) ; et
une électrode supérieure (50) formée sur la troisième couche diélectrique (46) ;
**caractérisé en ce que** la première couche diélectrique est une couche choisie dans le groupe constitué par une couche de $HfO_2$, une couche de $La_2O_3$ et une couche de $Pr_2O_3$ ;
et **en ce que** la troisième couche diélectrique est une couche choisie dans le groupe constitué par une couche de $HfO_2$, une couche de $La_2O_3$ et une couche de $Pr_2O_3$ ;
dans lequel chacune des première à troisième couches diélectriques (42, 44, 46) a une épaisseur de 2 nm à 10 nm.

**2.** Condensateur selon la revendication 1, dans lequel les première à troisième bandes interdites satisfont la condition suivante :

$$\text{la deuxième bande interdite} < \text{la première bande interdite} = \text{la troisième bande interdite}.$$

**3.** Condensateur selon la revendication 1, dans lequel les première à troisième bandes interdites satisfont la condition suivante :

$$\text{la deuxième bande interdite} < \text{la première bande interdite} < \text{la troisième bande interdite}.$$

**EP 1 507 285 B1**

**4.** Condensateur selon la revendication 1, dans lequel les première à troisième bandes interdites satisfont la condition suivante :

$$\text{la deuxième bande interdite} < \text{la troisième bande interdite} < \text{la première bande interdite.}$$

**5.** Condensateur selon l'une quelconque des revendications 1 à 4, dans lequel une couche diélectrique ayant une bande interdite située entre les première et deuxième bandes interdites est prévue en outre entre les première et deuxième couches diélectriques.

**6.** Condensateur selon l'une quelconque des revendications 1 à 5, dans lequel une couche diélectrique ayant une bande interdite située entre les deuxième et troisième bandes interdites est prévue en outre entre les deuxième et troisième couches diélectriques.

**7.** Capacité selon l'une quelconque des revendications 1 à 6, dans laquelle la deuxième couche diélectrique est une couche choisie dans le groupe constitué par une couche de $TiO_2$, une couche de $Ta_2O_5$, une couche de $SrTiO_3$, une couche de $BaTiO_3$, une couche de $PbTiO_3$, une couche de $(Ta, Nb)_2O_5$ et une couche de $(Ta, W)_2O_5$.

**8.** Dispositif à mémoire d'un dispositif semi-conducteur comprenant :

un transistor (72, 74, 76) ; et
un condensateur (40, 42, 44, 46, 50) relié au transistor, dans lequel le condensateur comprend un condensateur selon l'une quelconque des revendications précédentes.

# FIG. 1 (PRIOR ART)

| | |
|---|---|
| UPPER ELECTRODE | 14 |
| HfO₂ | 12 |
| LOWER ELECTRODE | 10 |

# FIG. 2 (PRIOR ART)

# FIG. 3 (PRIOR ART)

# FIG. 4 (PRIOR ART)

# FIG. 5

# FIG. 6

EP 1 507 285 B1

# FIG. 7

# FIG. 8

12

**EP 1 507 285 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20020116252 A
- US 20020030191 A